**Europäisches Patentamt**

**European Patent Office**

**Office européen des brevets**

(11) Numéro de publication : **0 331 577 B1**

(19)

(12) # FASCICULE DE BREVET EUROPEEN

(45) Date de publication du fascicule du brevet :
**15.07.92 Bulletin 92/29**

(51) Int. Cl.⁵ : **G04F 5/14, H03L 7/26**

(21) Numéro de dépôt : **89400567.7**

(22) Date de dépôt : **01.03.89**

(54) Horloge atomique.

(30) Priorité : **03.03.88 FR 8802706**

(43) Date de publication de la demande :
**06.09.89 Bulletin 89/36**

(45) Mention de la délivrance du brevet :
**15.07.92 Bulletin 92/29**

(84) Etats contractants désignés :
**CH DE ES FR GB IT LI NL SE**

(56) Documents cités :
**GB-A- 2 044 521
US-A- 4 314 209
US-A- 4 331 933
US-A- 4 449 105
US-A- 4 499 433**

(73) Titulaire : **SOCIETE D'ETUDES RECHERCHES
ET CONSTRUCTIONS ELECTRONIQUES
SERCEL
6, rue de Bel-Air
F-44470 Carquefou (FR)**

(72) Inventeur : **Rabian, Jean
19, Allée des Loriots
F-44980 Sainte Luce/Loire (FR)**
Inventeur : **Potet, Jean-Claude
7, rue des Chênes
F-44240 Suce/Erdre (FR)**
Inventeur : **Buchon, Michel
La Godelinière St. Mars du Desert
F-44850 Lignes (FR)**

(74) Mandataire : **Martin, Jean-Jacques et al
Cabinet REGIMBEAU 26, Avenue Kléber
F-75116 Paris (FR)**

EP 0 331 577 B1

## Description

La présente invention concerne le domaine des horloges atomiques, en particulier, mais non exclusivement, des étalons de fréquence à césium.

De nombreux étalons de fréquence atomique ont déjà été proposés. Les documents suivants décrivent par exemple de tels étalons : FR-A-1 287 180, FR-A-1 446 675, FR-A-1 594 565, FR-A-2 163 610, FR-A-2 206 539, FR-A-2 224 901, FR-A-2 316 836 et FR-A-2 327 671.

Pour l'essentiel, les étalons de fréquence atomique comprennent généralement :
  – un oscillateur à quartz,
  – un tube contenant un matériau (le plus souvant un métal alcalin tel que du césium ou du rubidium) dont les atomes présentent une transition spectrale hyperfine,
  – des moyens de commande aptes à générer, à partir de l'oscillateur à quartz, un signal de commande dont la fréquence correspond à la transition spectrale hyperfine et à appliquer ce signal de commande sur le tube pour faire interagir ce signal et les atomes du matériau contenu dans le tube, et
  – des moyens d'asservissement sensibles à la réponse du tube et adaptés pour modifier la fréquence de l'oscillateur à quartz de façon à centrer sensiblement la fréquence du signal de commande sur la fréquence de la transition spectrale hyperfine.

Certains étalons de fréquence comprennent des moyens de commande aptes à générer des signaux de test dont la fréquence contrôlée est située à l'extérieur du pic de Ramsey.

Dans le cadre des tubes à césium on utilise généralement la transition de résonance hyperfine qui se produit entre les états F = 4, mF = O, d'une part, et F = 3 et mF = O, d'autre part. La définition de ces états est explicitée dans les documents précités, en particulier dans les documents FR-A-1 594 565 et FR-A-2 316 836.

Pour provoquer une transition de l'un de ces états dans l'autre, l'atome doit soit fournir soit absorber une quantité d'énergie E égale à la différence d'énergie entre les états précités. La fréquence f du signal de commande requise pour provoquer un changement d'état est donnée par l'équation f = E/h ou h représente la constante de Planck.

La valeur de f pour la transition du césium de F = 4, mF = O à F = 3, mF = O est de 9 192 631 771, 59 Hz. Cette valeur de f sera dénommée Fr par la suite.

Les tubes contenant le matériau dont les atomes présentent une transition spectrale hyperfine sont connus en soi et ne seront donc pas décrits en détail par la suite. On notera cependant que les tubes à césium comprennent généralement : un four générant un faisceau d'atomes de césium à travers un collimateur, une cavité hyperfréquence au niveau de laquelle le signal de commande est couplé au jet d'atomes de césium, des moyens magnétiques sélecteurs d'état placés de part et d'autre de la cavité et un ensemble détecteur comprenant un ioniseur, un accélérateur, un spectomètre de masse et un multiplicateur d'électrons. Le multiplicateur d'électrons débite un courant de sortie proportionnel au nombre d'atomes arrivant sur le ioniseur et donc proportionnel au nombre d'atomes qui ont été amenés à l'état sélectionné, dans la cavité hyperfréquence.

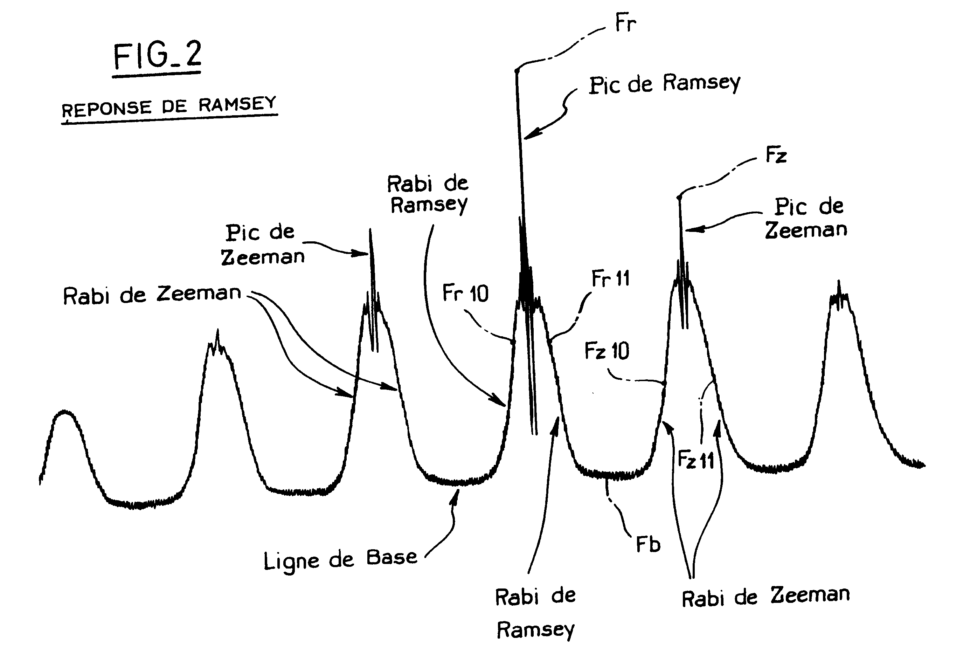

Le signal de résonance obtenu en sortie du tube, en fonction de la fréquence du signal de commande appliqué, est illustré schématiquement sur les figures 2, 3 et 4 annexées.

Le signal illustré sur la figure 2 est généralement dénommé réponse de Ramsey. Il représente la fonction de transfert globale du tube.

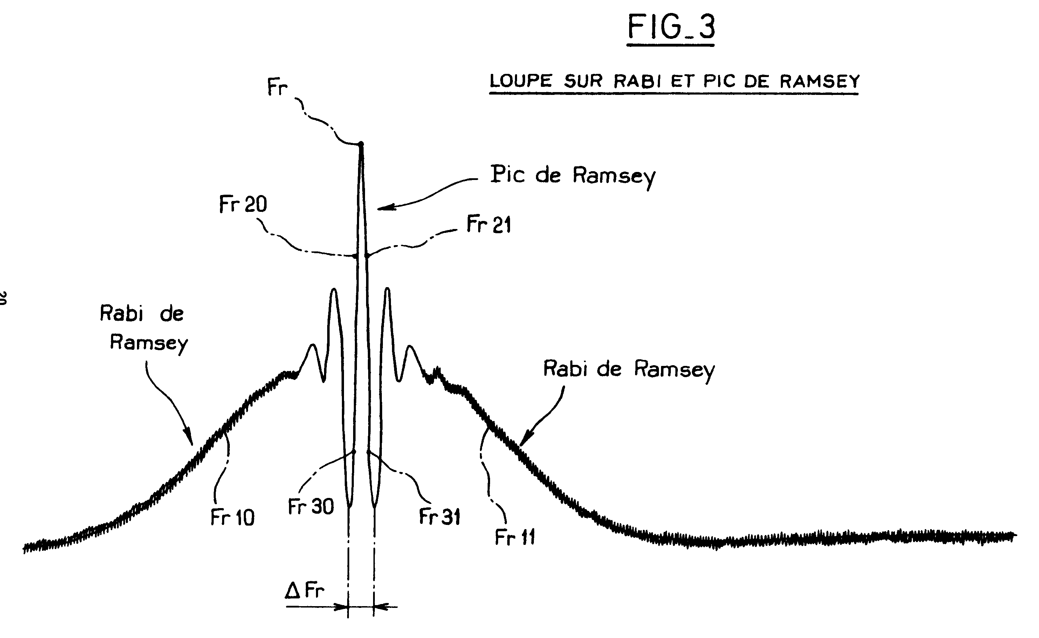

Le signal présente une amplitude maximale lorsque la fréquence du signal de commande appliqué est égale à la fréquence de la transition spectrale hyperfine Fr (soit 9 192 631 771, 59 Hz dans le cas du césium). Le pic centré sur cette fréquence Fr est dénommé pic de Ramsey. Celui-ci est encadré symétriquement par des oscillations parasites amorties de plus faible amplitude (voir figure 3). La ligne de base est reliée à ces oscillations parasites amorties par des flancs de base symétriques de pente variable, dénommés généralement Rabi de Ramsey.

La bande de fréquence Fr (voir figure 3) couverte par le pic central de Ramsey dépend directement de la longueur du jet d'atomes, donc de la longueur du tube. Plus le tube est long, moins le pic de Ramsey est large.

Certains étalons de fréquence atomique utilisés en laboratoire possèdent une longueur de 5m, ce qui permet de réduire la largeur du pic de Ramsey Fr à quelques 30 Hz. Mais les étalons de fréquence atomique utilisés industriellement, en particulier dans le cadre d'applications mobiles, possèdent des longueurs beaucoup plus courtes et la largeur du pic de Ramsey Fr est généralement de l'ordre de 1KHz.

La réponse de Ramsey comprend de plus, symétriquement de part et d'autre du pic de Ramsey central, des résonances auxiliaires qui apparaissent à intervalles de fréquence réguliers. L'amplitude de ces résonances auxiliaires est d'autant plus faible que celles-ci sont éloignées du pic de Ramsey. Les résonances auxiliaires placées de part et d'autre du pic de Ramsey et les plus proches de celui-ci présentent chacune un pic de plus forte amplitude (qui reste inférieur au pic de Ramsey) dénommé pic de Zeeman, des oscillations parasites amorties encadrant symétriquement le pic de Zeeman et des flancs de base de pente variable, dénommés généralement Rabi de Zeeman, qui relient les oscillations parasites amorties à la ligne de base.

Pour produire un signal utilisable pour la commande de l'oscillateur asservi, la fréquence du signal de commande appliqué à la cavité hyperfréquence est modulée autour de la fréquence de résonance atomique centrale Fr correspondant au pic de Ramsey.

Dans la pratique, dans les étalons de fréquence atomique commercialisés de nos jours, le signal de commande est modulé par une basse fréquence sinusoïdale à 137 Hz et sur une profondeur de +/- 250 Hz, soit la largeur du pic de Ramsey à mi-amplitude.

Le document US-A-4499433 décrit un système de verrouillage pour résonateurs d'étalonnage de fréquence.

Le but de ce système est d'identifier la crête de résonance maximale dans la réponse d'un résonateur.

Cette recherche de la crête de résonance maximale est opérée par un balayage de fréquence.

Ce balayage est obtenu par la programmation d'une rampe de tension sur l'entrée de commande de fréquence de l'oscillateur.

Simultanément une digitalisation et une mémorisation de la réponse du tube sont effectuées.

Un analyseur de crêtes analyse chaque valeur de crête et compare la valeur analysée avec des valeurs antérieures de manière à sélectionner la crête maximale.

Le document précise que l'oscillateur peut être étagé par incréments sur une gamme de 10kHz, avec au moins 200 incréments, typiquement 200 à 300, sur la plage de fréquence. Un microprocesseur commande les 200 à 300 incréments. Chaque valeur numérique représentant la sortie du résonateur, est comparée avec la valeur préalablement stockée dans le microprocesseur. Si la nouvelle valeur numérique est supérieure à cette valeur préalablement stockée, la nouvelle valeur remplace celle-ci. Si la nouvelle valeur est inférieure à la valeur stockée, cette dernière n'est pas changée. De cette manière, la valeur emmaganisée représente la crête de résonance maximale.

Le document US-A-4499433 ajoute que le microprocesseur peut être utilisé pour analyser la symétrie de la courbe sinusoïdale de part et d'autre de la crête qui est ainsi sélectionnée comme étant la crête maximale.

La valeur retenue pour la crête est confirmée lorsqu'une symétrie est détectée. Par contre, si une symétrie n'est pas obtenue, la crête précédemment sélectionnée comme étant la crête maximale est rejetée, car elle n'est pas valable et l'appareil redémarre pour sélectionner automatiquement la crête positive maximale.

Le document US-A-4449105 décrit un procédé de contrôle de fréquence en temps partagé pour accord d'une cavité Maser.

Le procédé décrit dans ce document consiste à :
– produire périodiquement un premier signal d'erreur représentant la différence entre la fréquence d'un signal d'excitation injecté et la fréquence d'émission stimulée, et utiliser ce premier signal d'erreur pour ajuster la fréquence du signal d'excitation injecté, puis
– produire périodiquement, et en alternance avec le premier signal d'erreur, un second signal d'erreur qui représente la différence entre la fréquence de résonance de la cavité et la fréquence du signal d'excitation, et utiliser ce second signal d'erreur pour ajuster la fréquence de résonance de la cavité, en agissant sur une capacité variable.

Le document US-A-4331933 décrit un circuit d'asservissement de la puissance micro-ondes dans une source à jet de Césium.

Ce document expose que l'écart de fréquence entre le pic central de la réponse et des pics adjacents est variable en fonction de la puissance micro-ondes.

Il propose ensuite d'utiliser cette propriété pour asservir la puissance micro-ondes à une consigne d'écart de fréquence.

Les étalons de fréquence atomique jusqu'ici proposés ont déjà rendu de grands services. Ils présentent cependant différents inconvénients.

L'inconvénient principal des étalons classiques semble que les contrôles d'acquisition du pic central de la réponse de Ramsey sont peu fiables.

Des inconvénients secondaires des étalons classiques semblent dûs au fait que :
– ces étalons classiques sont sensibles à l'environnement notamment à la température,
– la linéarité du modulateur de fréquence sinusoïdale à 137 Hz est difficile à maîtriser,
– les réglages sont nombreux et complexes,
– le coût global des dispositifs est élevé.

La présente invention a pour but général d'éliminer les inconvénients précités de la technique antérieure et de garantir une excellente fiabilité à long terme de l'horloge.

Cet objectif est atteint selon un aspect fondamental de la présente invention grâce à l'utilisation de moyens de commande qui, lors d'une phase de démarrage, appliquent alternativement sur le tube, deux signaux de commande dont les fréquences sont supposées symétriques de la raie centrale de Ramsey et de moyens d'asservissement qui modifient la fréquence de l'oscillateur à quartz pour minimiser l'écart entre les réponses du tube à ces deux signaux de commande.

Le choix de la fréquence des signaux sera explicité par la suite. Ces signaux permettent de centrer initialement la fréquence du signal de commande sur le Rabi de Ramsey et de vérifier que le signal de commande n'est pas centré par erreur sur une oscillation parasite adjacente au pic de Ramsey.

Les moyens de commande comprennent avantageusement un synthétiseur de fréquences à commutation rapide contrôlé par microprocesseur ayant des pas de fréquence faibles. La plage de fonctionnement du synthétiseur peut être avantageusement de l'ordre de 55 KHz.

Selon un second aspect important, la présente invention propose d'intégrer aux moyens de commande un système remplissant la fonction de vernier pour permettre l'ajustage de la fréquence du signal de commande. Le système vernier proposé permet l'ajustage de la fréquence avec une résolution de $10^{-13}$ dans une plage de $2.10^{-10}$.

Selon un troisième aspect important, la présente invention propose des moyens amplificateurs-intégrateurs du signal de sortie du tube, permettant un interfaçage court et stable entre le signal de sortie du tube et un convertisseur analogique/numérique.

Selon un quatrième aspect important, la présente invention propose des moyens permettant d'optimiser la résolution de la commande d'asservissement de l'oscillateur à quartz. Ces moyens comprennent pour l'essentiel un convertisseur numérique/analogique, une porte analogique à temps de fermeture contrôlé et un intégrateur. L'optimisation de la résolution est obtenue en contrôlant l'amplitude et la durée d'impulsions de charge appliquées à l'intégrateur.

D'autres caractéristiques, buts et avantages de la présente invention apparaîtront à la lecture de la description détaillée qui va suivre, et en regard des dessins annexés, donnés à titre d'exemple non limitatif et sur lesquels :

    – la figure 1 représente une vue schématique, sous forme de blocs fonctionnels de l'ensemble de l'horloge atomique conforme à la présente invention,

    – la figure 2 représente la réponse globale de Ramsey issue d'un tube à césium,

    – la figure 3 représente une vue de détail agrandie du Rabi et du pic de Ramsey issus d'un tube à césium,

    – la figure 4 représente une vue de détail agrandie du pic Zeeman issu d'un tube à césium,

    – la figure 5 illustre schématiquement le contrôle du centrage de la fréquence du signal de commande sur la fréquence de transition hyperfine du césium,

    – la figure 6 représente une vue schématique sous forme de blocs fonctionnels du synthétiseur de fréquence intégré dans l'horloge atomique conforme à la présente invention,

    – la figure 7 représente une vue schématique sous forme de blocs fonctionnels du vernier de réglage fin de fréquence, intégré dans l'horloge atomique conforme à la présente invention,

    – la figure 8 représente schématiquement différents signaux prélevés sur le vernier précité pour expliciter son fonctionnement,

    – la figure 9 représente schématiquement, sous forme de blocs fonctionnels, des moyens amplificateurs-intégrateurs du signal de sortie du tube,

    – la figure 10 représente des signaux électriques prélevés en différents points de ces moyens amplificateurs-intégrateurs pour expliciter leur fonctionnement,

    – la figure 11 représente une vue schématique sous forme de blocs fonctionnels de moyens permettant d'optimiser la résolution de la commande d'asservissement de l'oscillateur à quartz,

    – la figure 12 illustre schématiquement le fonctionnement général de l'horloge atomique conforme à la présente invention, et

    – la figure 13 illustre sous forme de blocs fonctionnels un exemple de réalisation d'un sous-ensemble assurant des fonctions de multiplication et d'addition de fréquences, intégré aux moyens de commande conformes à la présente invention.

Dans la suite de la description, on mentionnera des valeurs précises de fréquences générées par les différents sous-ensembles d'une horloge atomique conforme à un mode de réalisation préférentiel de la présente invention, à des fins de clarification.

Cependant, les valeurs précises de fréquences indiquées dans la suite de la description ne doivent en aucune façon être considérées comme limitatives.

## STRUCTURE GENERALE DE L'HORLOGE ATOMIQUE

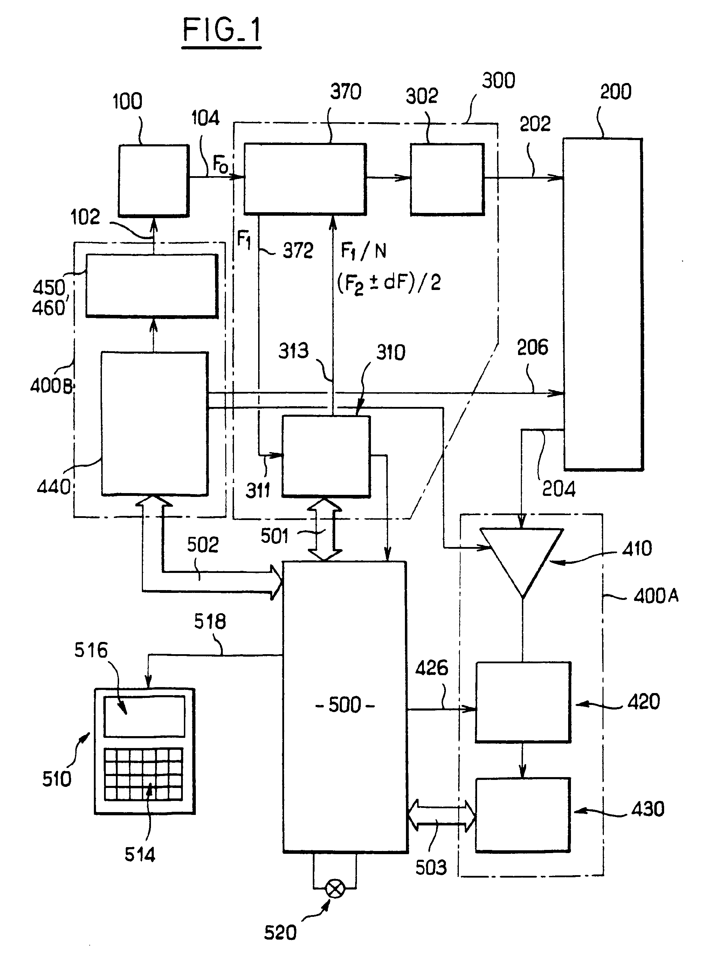

Comme illustré sur la figure 1 annexée, pour l'essentiel l'horloge atomique conforme à la présente invention comprend :

    – un oscillateur 100,

    – un tube 200,

    – des moyens de commande 300,

    – des moyens d'asservissement 400, et

    – une unité centrale 500.

L'oscillateur 100 est avantageusement un oscillateur à quartz. La fréquence Fo issue de l'oscillateur 100 peut être réglée à l'aide d'un signal externe appliqué sur l'entrée 102 de l'oscillateur. La fréquence Fo du signal disponible sur la sortie 104 de l'oscillateur est par exemple de 10 MHz.

Le tube 200 contient un matériau dont les atomes présentent une transition spectrale hyperfine. Le tube 200 est de préférence un tube au césium, le cas échéant au rubidium.

Le signal de commande destiné à provoquer le changement d'état des atomes de césium dans la cavité hyperfréquence est appliqué sur l'entrée 202 du tube. Le signal de courant proportionnel au nombre d'atomes arrivant sur le ioniseur du tube 200 est disponible sur la sortie 204.

On notera à l'examen de la figure 1 que le tube 200 possède en outre une entrée auxiliaire 206. Celle-ci est reliée à un enroulement conçu pour créer un champ faible et homogène dans la cavité d'interaction hyperfréquence. Ce champ est connu généralement sous le nom de champ C, comme indiqué par exemple dans le document FR-A-2 316 836.

L'unité centrale 500, de façon classique en soi, comprend un microprocesseur associé à une horloge interne et à des mémoires. L'unité centrale 500 peut être contrôlée à distance à partir d'un périphérique 510, à clavier 514 et écran 516. Le périphérique 510 est relié à l'unité centrale 500 par une liaison série 518. L'unité centrale 500 est par ailleurs reliée à des témoins d'alarme 520, tels que des témoins lumineux.

On va maintenant décrire plus en détail les moyens de commandé 300 et les moyens d'asservissement 400 conformes à la présente invention.

## MOYENS DE COMMANDE 300

La fonction principale des moyens de commande 300 est de générer, à partir de l'oscillateur à quartz 100 un signal de commande dont la fréquence correspond à la transition spectrale hyperfine ou est modulée symétriquement par rapport à la fréquence correspondant à la transition spectrale hyperfine, pour appliquer ce signal de commande sur l'entrée 202 du tube 200.

Cependant, dans le cadre de la présente invention, les moyens de commande 300 ont également pour fonction auxiliaire de générer des signaux de test, qui seront précisés par la suite, dont la fréquence diffère de la fréquence correspondant à la transition spectrale hyperfine du matériau contenu dans le tube 200, ainsi que des signaux fixes échelonnés de 100 KHz à 10 MHz d'une part, et un signal d'interruption IT. Le signal d'interruption IT peut présenter par exemple une période de 17, 92 msec.

Le signal de commande de base et les signaux de test sont générés à partir d'un signal programmable par pas de F1/N additionné à des signaux dérivés de l'oscillateur à quartz 100.

A titre d'exemple F1 = 90 MHz et N est programmable de 504 à 710.

Le principe de génération d'un signal de commande de fréquence Fr est le suivant.

Pour N = 683, la fréquence F1/N est égale à 131 771,6 Hz. Cette fréquence F1/N est additionnée avec un signal de 12,5 MHz pour obtenir un signal F4 de 12 631 771,6 Hz. Ce signal F4 est additionné avec le signal de 90 MHz multiplié par 102 pour arriver à 9 192 631 771,6 Hz qui correspond à la fréquence Fr de la transition du césium. Pour générer une excursion de fréquence de +/- 193 Hz autour de la fréquence centrale Fr, afin de produire un signal utilisable pour la commande de l'oscillateur asservi 100, il suffit de programmer alternativement N = 682 et N = 684. Ces dispositions seront explicitées par la suite.

Pour l'essentiel, les moyens de commande 300 comprennent un circuit 370 assurant des fonctions de multiplication et d'addition de fréquences, un circuit 302 assurant la fonction de multiplication de fréquences par 51 et un circuit 310 constituant un synthétiseur de fréquences programmable.

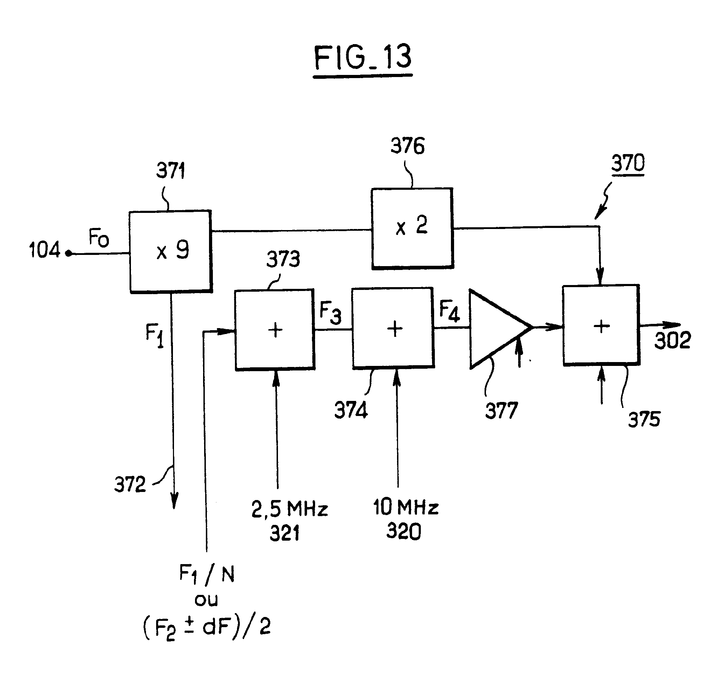

Le circuit 370 comprend (voir figure 13) un premier étage 371 assurant une multiplication par 9 de la fréquence Fo du signal d'horloge issu de l'oscillateur 100. Le signal F1 de 90 MHz disponible sur la sortie 372 du circuit 370 est appliqué sur l'entrée 311 du synthétiseur de fréquences 310.

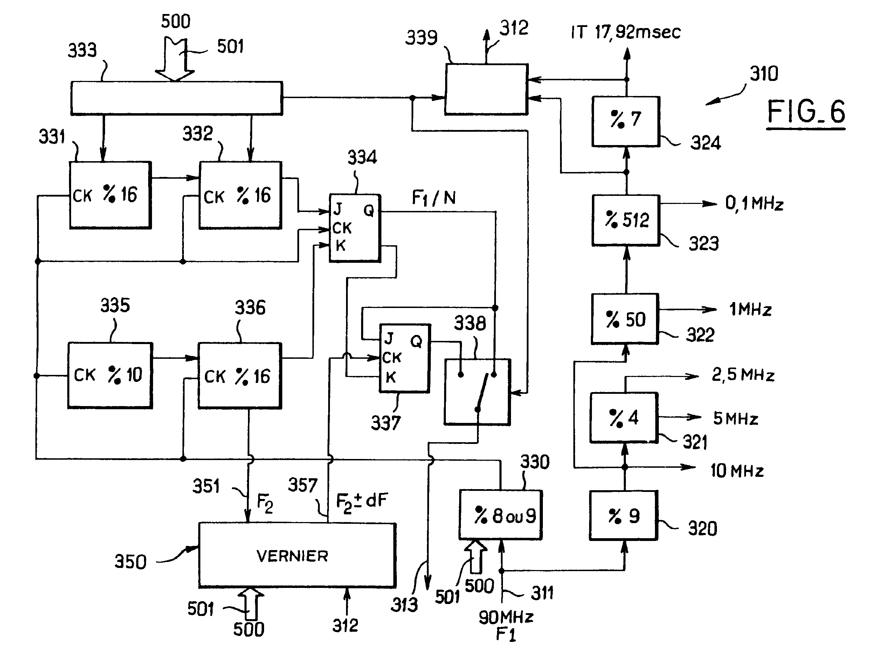

Le signal F1 de 90 MHz est tout d'abord dirigé vers une chaîne de diviseurs de fréquences 320, 321, 322, 323 et 324, montés en cascade comme illustré sur la figure 6. Ces diviseurs de fréquences peuvent opérer par exemple respectivement des divisions de fréquence par 9, 4, 50, 512 et 7, pour générer des signaux échelonnés, respectivement de 10 MHz, 5 MHZ, 2,5 MHz, 1 MHz et 0,1 MHz. Les sorties des diviseurs 320 à 323 précitées constituent les sorties principales de l'étalon de fréquence. Les signaux disponibles sur ces sorties sont en effet parfaitement stables.

Par ailleurs, le diviseur 324 génère à sa sortie le signal d'interruption IT précité, d'une période par exemple de 17,92 msec.

Le signal de fréquence F1 disponible sur l'entrée 311 est par ailleurs appliqué à une chaîne de diviseurs de fréquence programmable générant à leur sortie le signal recherché F1/N.

Plus précisément le signal F1 de 90 MHz disponible sur l'entrée 311 est appliqué à un diviseur programmable 330 assurant une division par 8 ou 9.

Le facteur de division du diviseur 330 est défini par l'unité centrale 500 par l'intermédiaire d'un bus 501.

La sortie du diviseur 330 est appliquée aux entrées d'horloge CK de deux compteurs diviseur par 16, référencés 331, 332 connectés en cascade.

Le facteur de division des compteurs diviseurs 331, 332 est défini par un ensemble de bascules 333 définissant l'état initial des compteurs diviseurs 331, 332. L'état des bascules 333 est lui-même commandé par l'unité centrale 500 par l'intermédiaire du bus 501.

En parallèle, le signal issu du diviseur 330 est appliqué sur l'entrée d'horloge CK de deux compteurs diviseurs 335, 336 montés en cascade et assurant une division par 10 et 16 respectivement.

Le synthétiseur 310 comprend une bascule JK 334. L'entrée J de la bascule 334 est reliée à la sortie du compteur diviseur 332. L'entrée d'horloge CK de la bascule 334 est reliée à la sortie du diviseur 330. L'entrée K de la bascule 334 est reliée à la sortie du diviseur 336.

Le signal F1/N est disponible sur la sortie Q de la bascule 334.

Comme indiqué précédemment, l'horloge atomique conforme à l'invention comprend en outre un vernier 350 permettant un réglage fin de la fréquence issue du synthétiseur de fréquence.

## VERNIER DE REGLAGE FIN DE FREQUENCE 350.

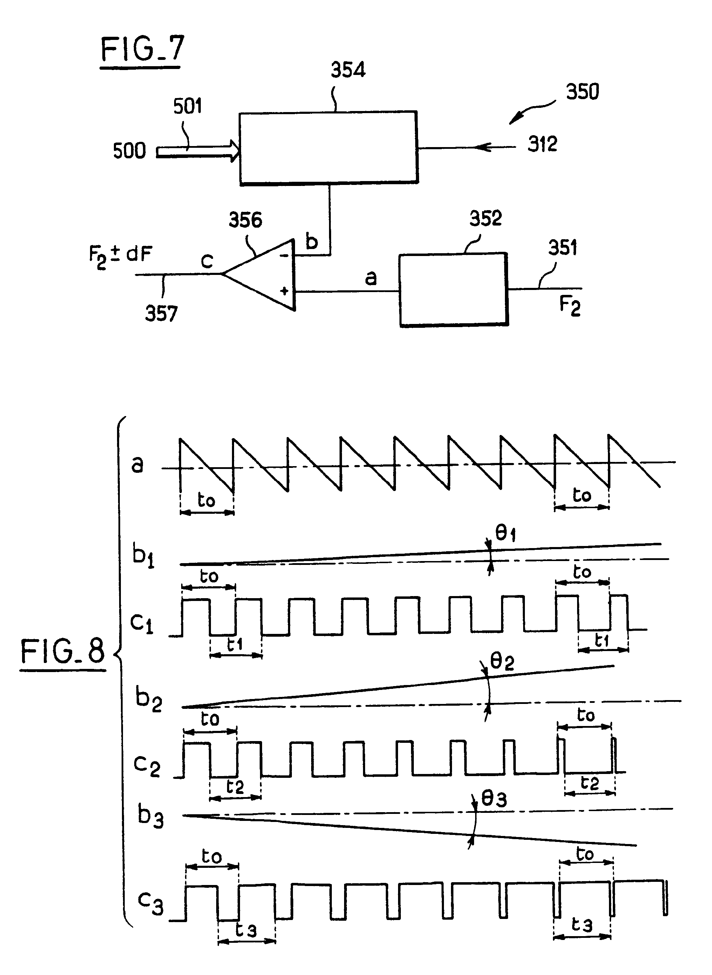

Le vernier 350 est illustré sur la figure 7.

Le vernier 350 comprend un premier générateur de rampe linéaire 352, un second générateur de rampe 354 et un comparateur 356.

L'entrée 351 du générateur de rampe linéaire 352 est reliée à une sortie du diviseur 336 qui génère un signal F2 à 263 543,2Hz (soit 113 771,6 multiplié par 2). Le générateur de rampe 352 est donc récurrent à cette fréquence F2.

Le signal en dents de scie obtenu à la sortie du générateur de rampe 352 est illustré sur la première ligne de la figure 8. On notera que ce signal est symétrique par rapport à la masse. Sa période constante est référencée $t_0$. Il possède des fronts ascendants raides suivis de pentes descendantes rectilignes.

Le générateur de rampe 354 reçoit sur son entrée une suite d'impulsions dont la période correspond à la période des signaux d'interruption IT, soit avantageusement de 17,92 msec. Les impulsions appliquées à l'entrée du générateur de rampe 354 sont générées à la sortie 312 d'un module 339 piloté par les bascules 333 et les sorties des diviseurs de fréquence 323 et 324.

Le générateur de rampe 354 peut être formé d'un intégrateur de Miller. La pente de la rampe issue du générateur 354 est réglée en amplitude et en polarité, grâce à un convertisseur digital analogique à partir de l'unité centrale 500, par l'intermédiaire du bus 501.

On a illustré sur la deuxième ligne de la figure 8 un exemple de rampe $b_1$ issue de générateur 354, possédant une pente de polarité positive et d'amplitude 1.

On a illustré sur la quatrième ligne de la figure 8 un autre exemple de rampe $b_2$ issue du générateur 354, possédant une pente de polarité positive et d'amplitude 2.

Enfin, on a illustré sur la sixième ligne de la figure 8 une rampe $b_3$ issue du générateur 354, possédant une pente de polarité négative et d'amplitude 3.

Les signaux a et b issus des deux générateurs de rampe 352 et 354 sont appliqués sur les entrées du comparateur 356. Le comparateur 356 génère à sa sortie un signal logique c en créneaux dont la fréquence correspond à la fréquence F2 du signal appliqué sur l'entrée 351 plus ou moins une valeur dF définie par la valeur programmée en sortie du convertisseur numérique analogique associé.

En effet, l'homme de l'art comprendra aisément que si les fronts montants des créneaux du signal c issu du comparateur 356 possèdent une période constante $t_0$ égale à la période du signal en dents de scie a issu du générateur 352, la période $t_1$, $t_2$ ou $t_3$ séparant les fronts descendants des créneaux du signal c issu du comparateur 356, est modulée par la polarité et l'amplitude de la pente de la rampe b issue du générateur 354. Cependant, la période $t_1$, $t_2$ ou $t_3$ séparant les fronts descendants du signal c reste constante pour une rampe b de pente constante. L'excursion de fréquence dF peut donc être réglée à partir de la polarité et de l'amplitude de la pente de la rampe b.

Le signal F2 +/- dF issu de la sortie 357 du comparateur 356, c'est-à-dire du vernier 350 est appliqué sur l'entrée d'horloge CK d'une bascule 337. L'entrée J de cette bascule 337 est reliée à la sortie Q de la bascule 334, tandis que l'entrée K de la bascule 337 est reliée à la sortie Q de la bascule 334. La bascule 337 génère en sortie un signal de fréquence (F2 +/- dF)/2, on notera que lorsque dF = O, (F2 +/- dF)/2 = F1/683.

Le synthétiseur de fréquence 310 comprend enfin, en sortie, une porte 338 servant d'inverseur. Les deux entrées de la porte 338 sont reliées respectivement aux sorties Q des bascules 334 et 337. La sortie de la porte 338, qui constitue la sortie du synthétiseur de fréquence 310 est référencée 313. La commande de la commutation de la porte 338 est assurée par les bascules 333 pilotées par l'unité centrale 500.

Lorsque la sortie 313 du synthétiseur de fréquence 310 est reliée à la sortie Q de la bascule 337, le vernier 350 est en service, et la fréquence (F2 +/- dF)/2 du signal de commande généré peut être réglée finement en fonction de l'amplitude et la polarité de la pente de la rampe issue du générateur 354.

Lorsque la sortie 313 du synthétiseur de fréquence est reliée à la sortie Q de la bascule 334, le vernier 350 est hors service. Les signaux issus de la sortie 313 du synthétiseur de fréquence constituent les signaux de test de fréquence F1/N.

Comme indiqué précédemment et illustré sur la figure 13, à l'intérieur du circuit 370 le signal de fréquence F1/N ou (F2 +/- dF)/2 est additionné dans un étage mélangeur 373 au signal de 2,5 MHz issu du diviseur 321 pour obtenir un signal intermédiaire de fréquence F3, puis dans un étage mélangeur 374 au signal de 10 MHz issu du diviseur 320 pour obtenir un signal de fréquence F4 de l'ordre de 12,6 MHz. Le signal F4 obtenu est ensuite additionné à un signal de 180 MHz dans un étage mélangeur 375. Le signal de 180 MHz est généré dans l'étage 376 qui multiplie par 2 la fréquence F1 de 90 MHz. La fréquence de 180 MHz est ensuite multipliée par 51 dans l'étage 302. Le signal de commande recherché, qui est appliqué sur l'entrée 202 du tube, est disponible à la sortie de l'étage 302.

Le vernier 350 peut être utilisé pour provoquer en recalage de phase entre deux horloges en programmant une dérive de fréquence contrôlée pendant un temps déterminé.

## MOYENS 400A
## AMPLIFICATEURS-INTEGRATEURS DU SIGNAL DE SORTIE DU TUBE

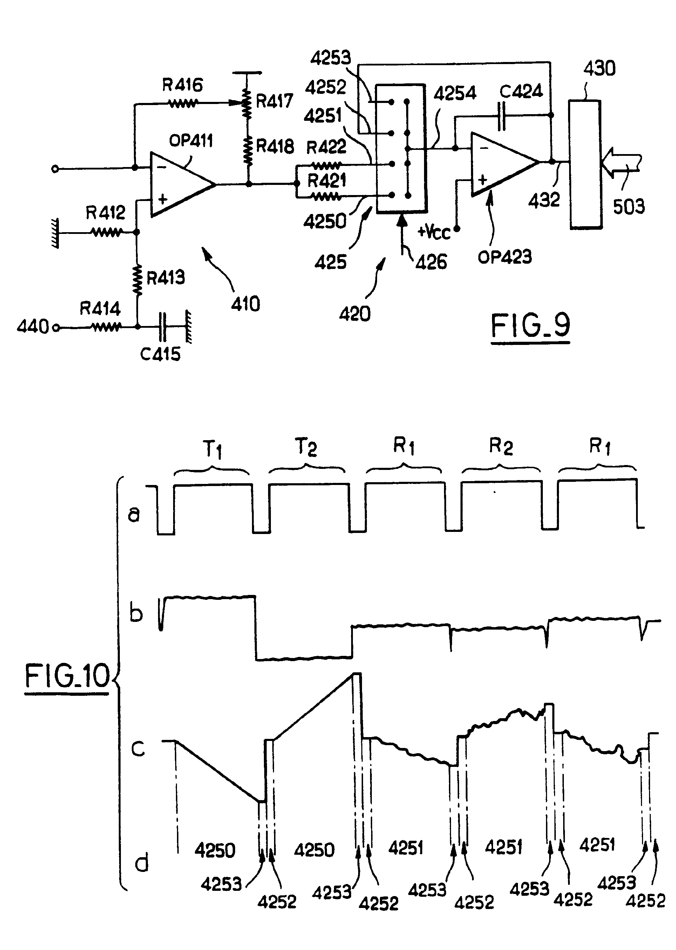

Ces moyens sont illustrés schématiquement sur la figure 9. Ces moyens 400 comprennent un étage amplificateur 410, un étage intégrateur 420 et un convertisseur analogique numérique 430.

L'étage pré-amplificateur 410 est basé sur un amplificateur opérationnel OP 411.

Celui-ci reçoit sur son entrée inverseuse le signal provenant de la sortie 204 du tube 200.

La sortie de l'amplificateur opérationnel OP 411 est reliée à la masse par l'intermédiaire d'une résistance R 418 et d'un potentiomètre R 417 en série. Le curseur du potentiomètre R 417 est rebouclé sur l'entrée inverseuse de l'amplificateur opérationnel OP 411 par l'intermédiaire d'une résistance série R 416. Le gain de l'étage amplificateur 410 est ajusté par réglage du potentiomètre R 417.

L'entrée non inverseuse de l'amplificateur opérationnel OP 411 est reliée à un ensemble de réglage d'offset.

L'entrée non inverseuse de OP 411 est reliée à la masse par l'intermédiaire d'une résistance R 412 d'une part, et par l'intermédiaire d'une branche comprenant en série une résistance R 413 et un condensateur C 415 d'autre part.

Le point commun à la résistance R 413 et au condensateur C 415 reçoit par l'intermédiaire d'une résistance R 414 une tension de réglage d'offset issue d'un convertisseur numérique analogique 440, selon des dispositions qui seron définies par la suite.

L'étage intégrateur 420 est formé d'un intégrateur de Miller basé sur un amplificateur opérationnel OP 423.

L'entrée inverseuse de l'amplificateur opérationnel OP 423 est précédée d'une porte analogique 425. Celle-ci possède quatre entrées et une sortie. La sortie de la porte 425 peut être reliée alternativement à l'une quelconque des entrées précitées, en fonction d'un signal pilote 2 bits appliqué sur l'entrée 426 de la porte et provenant de l'unité centrale 500.

La sortie de l'étage amplificateur 410 est reliée par une première résistance R 421 à la première entrée 4250 de la porte 425. La sortie de l'étage amplificateur 410 est reliée par l'intermédiaire d'une seconde résistance R 422 à la seconde entrée 4251 de la porte 425.

La troisième entrée 4252 de la porte 425 est reliée à la sortie de l'amplificateur opérationnel OP 423. La quatrième entrée 4253 de la porte 425 est en l'air. La sortie 4254 de la porte 425 est reliée à l'entrée inverseuse de l'amplificateur opérationnel OP 423.

Un condensateur C 424 relie l'entrée inverseuse de l'amplificateur opérationnel OP 423 à sa sortie.

L'entrée non inverseuse de l'amplificateur opérationnel OP 423 est reliée à une borne d'alimentation posivite + Vcc.

La sortie de l'intégrateur 420, constitué par la sortie de l'amplificateur opérationnel OP 423, est reliée à l'entrée 432 du convertisseur analogique/numérique 430. Ce dernier est connecté en sortie, par l'intermédiaire du bus 503, à l'unité centrale 500.

La porte 425 a pour fonction de choisir le gain d'amplification de l'intégrateur 420, de mémoriser temporairement la tension de sortie obtenue pour permettre sa conversion numérique par le convertisseur 430, et de décharger cycliquement le condensateur C 424 d'intégration avant une acquisition suivante.

Comme cela sera précisé par la suite, le fonctionnement de l'horloge atomique conforme à la présente invention est cadencé par le signal d'interruption IT d'une période de 17,92 msec. Pendant chacune de ces périodes les moyens de commande 300 génèrent un signal de commande ou un signal de test de fréquence choisie définie par le synthétiseur de fréquence 310. Les moyens d'asservissement 400 illustrés sur la figure 9 ont pour but d'assurer une conversion numérique du signal de sortie du tube, pour chacune de ces périodes élémentaires de 17,92 msec.

On a illustré sur la première ligne a de la figure 10 le signal d'interruption IT d'une période de 17,92 msec.

On a représenté sur la deuxième de la figure 10, le signal b correspondant obtenu en sortie de l'étage pré-amplificateur 410. Enfin, on a illustré sur la troisième ligne C de la figure 10 le signal correspondant obtenu en sortie de l'intégrateur 420.

Les deux premières périodes T1, T2 de 17,92 msec des signaux illustrés sur la figure 10 correspondent arbitrairement à l'application sur l'entrée 202 du tube 200 de fréquences de test non symétriques de la fréquence centrale Fr du pic de Ramsey. La différence des niveaux du signal issu de la sortie 204 du tube 200, entre ses deux premières périodes, étant élevée, l'étage intégrateur 420 est commandé en gain faible par l'unité centrale 500 par liaison de la sortie 4254 sur la première entrée 4250. Le gain de l'étage intégrateur 420 est alors défini par la résistance R421.

Dans les périodes suivantes R1, R2 des signaux illustrés sur la figure 10, on suppose que des signaux de commande présentant un faible écart de fréquence alternativement positif et négatif, par exemple de +/- 193 Hz, par rapport à la fréquence centrale Fr du pic de Ramsey, sont appliqués sur l'entrée 202 du tube 200.

Les différences de niveaux détectés sur le signal de sortie du tube 200 étant alors faibles, l'intégrateur 420 doit présenter un gain fort. Pour cela, la sortie 4254 est reliée à l'entrée 4251. Le gain de l'intégrateur 420 est défini par la résistance R 422. Celle-ci possède avantageusement une valeur 10 fois plus faible que la résistance R421, pour définir un rapport de 10 entre les deux gains possibles de l'intégrateur 420.

A la fin de chaque cycle de mesure de 17,92 msec, la sortie 4254 est reliée à l'entrée 4253 pour mémoriser la valeur obtenue sur la capacité C 424, et permettre au convertisseur 430 d'assurer la conversion numérique. Ensuite, la sortie 4254 est reliée à l'entrée 4252 pour décharger le condensateur d'intégration 424 avant une acquisition suivante.

La nature de l'entrée 4250, 4251, 4252 ou 4253 reliée à la sortie de la porte 425 est définie sur la quatrième ligne de la figure 10.

Le temps de liaison des entrées 4253 et 4252, à la sortie 4254 pour être de l'ordre de 1 msec respectivement.

## MOYENS 400B D'ASSERVISSEMENT DE L'OSCILLATEUR A QUARTZ 100

Ces moyens 400 ont pour but d'optimiser la résolution de l'asservissement.

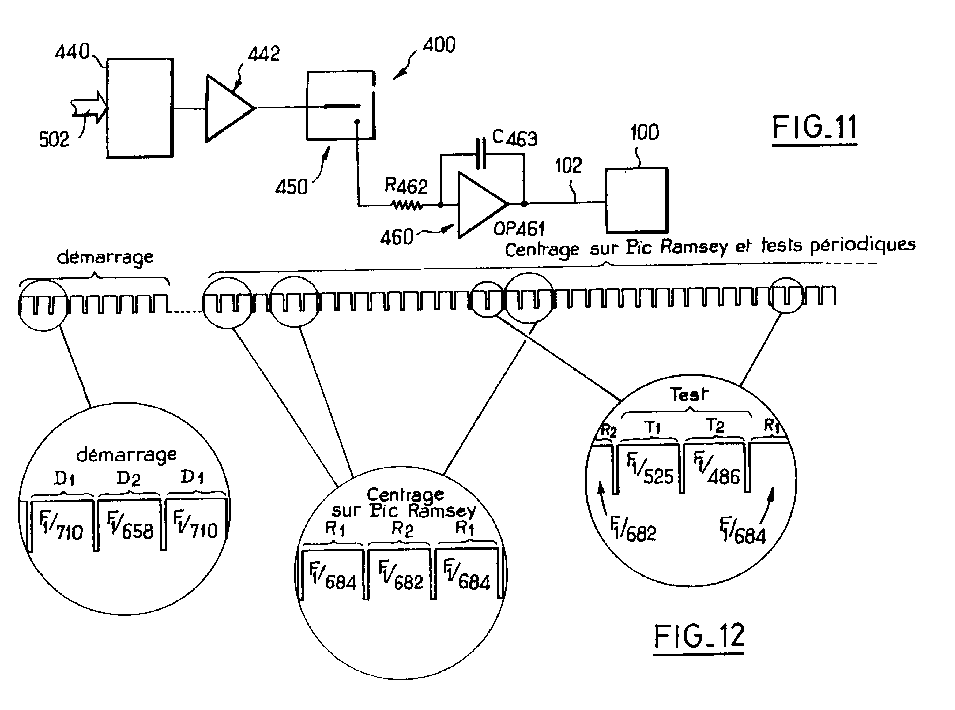

Pour l'essentiel, les moyens 400 d'asservissement illustrés sur la figure 11 comprennent un convertisseur numérique/analogique 440, une porte analogique 450 et un étage intégrateur 460.

Le convertisseur numérique/analogique 440 est relié à l'unité centrale 500 par l'intermédiaire du bus 502.

La sortie du convertisseur 440 est reliée à l'entrée de la porte 450. Le cas échéant, un étage amplificateur 442 peut être intercalé entre la sortie du convertisseur 440 et la porte 450.

L'intégrateur 460 définit une bouche d'asservissement de fréquence du deuxième ordre. Cette disposition présente l'avantage d'appliquer des constantes de filtrage importantes sans amener d'erreurs de phase en fonction de l'instabilité de l'oscillateur.

L'étage intégrateur 460 est formé d'un intégrateur de Miller. Celui-ci comprend un amplificateur opérationnel OP 461. L'entrée de l'amplificateur opérationnel OP 461 est relié à la sortie de la porte 450 par l'intermédiaire d'une résistance R 462. L'entrée de l'amplificateur opérationnel OP 461 est relié à sa sortie par l'intermédiaire d'une capacité d'intégration C 463.

Le temps de fermeture de la porte analogique 450 est contrôlé pour définir la résolution souhaitée.

En effet, pour un oscillateur 100 ayant un tirage de fréquence de $+/- 2 \cdot 10^{-7}$, pour un signal pilote sur son entrée 102 de $+/- 4$ volts, une résolution de commande de 2 mvolts obtenue directement à la sortie d'un convertisseur numérique/analogique 440 de 12 bits, produirait un saut de fréquence de $10^{-10}$.

Les moyens 400 illustrés sur la figure 11, conformes à la présente invention, permettent de réduire la résolution à $10^{-13}$, en ramenant la résolution du signal pilote appliqué sur l'entrée 102 à 2 μvolts.

Pour cela, en supposant par exemple que la résistance R 462 est de 33 Kohms et que la capacité C 463 est de 1 μF, il suffit que l'unité centrale 500 contrôle la fermeture de la porte analogique 450 pendant 33 μsec pour obtenir un pas de 2 μvolts.

En d'autres termes, l'augmentation de résolution est obtenue dans le cadre de la présente invention en générant une impulsion de charge de l'intégrateur 460 d'une part modulée en amplitude par le convertisseur numérique analogique 440, d'autre part modulée en durée par la porte analogique 450 sous contrôle de l'unité centrale 500.

## FONCTIONNEMENT GENERAL DE L'HORLOGE ATOMIQUE

Comme indiqué précédemment, le fonctionnement de l'horloge est cadencé en périodes élémentaires de 17,92 msec par le signal d'interruption IT issu du synthétiseur de fréquence 310.

Au cours d'une période donnée de 17,92 msec, les moyens de commande 300 appliquent sur l'entrée 202 du tube 200 un signal de fréquence déterminée. La fréquence du signal varie d'une période de cadencement à une autre.

La fréquence de ce signal est définie par addition d'un signal de commande ou de test programmable par pas F1/N de 90 MHz/N ou un signal à réglage fin de fréquence (F2 +/- dF)/2 de (90 MHz/683) +/-dF avec un signal de 12,5 MHz puis avec un signal de 90 MHz x 102.

Le fonctionnement de l'horloge se décompose en fait en une phase initiale de démarrage suivie d'une phase de fonctionnement normal de poursuite du pic de Ramsey.

La phase de fonctionnement normal de poursuite du pic de Ramsey comprend elle-même périodiquement des cycles élémentaires de test qui seront explicités par la suite.

## PHASE DE DEMARRAGE

Pendant la phase de démarrage, l'asservissement de l'oscillateur à quartz 100 correspond à un centrage sur le Rabi de Ramsey.

Pour cela, les moyens de commande 300 appliquent cycliquement, sur l'entrée 202 du tube 200, au cours de périodes de 17,92 msec successives (référencées D1 et D2 sur la figure 12), alternativement un signal Fr 10, Fr 11 de fréquence Fr +/- 5KHz. Ces fréquences Fr 10 et Fr 11 sont donc grossièrement symétriques de la raie centrale de Ramsey Fr.

Ces fréquences Fr 10, Fr 11 peuvent être générées en sortie des moyens de commande 300 en programmant alternativement, en sortie du synthétiseur de fréquence 310, une fréquence F1/N égale à F1/710 et F1/658, soit 126 760 Hz et 136 778 Hz.

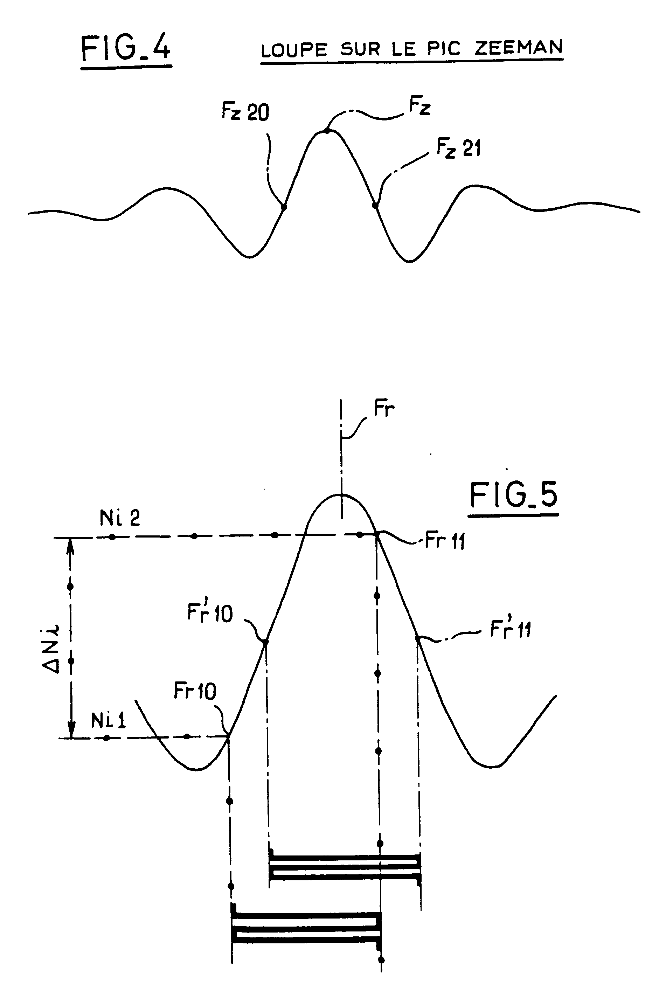

L'homme de l'art comprendra aisément que, comme cela est illustré sur la figure 5 annexée, les flancs du Rabi de Ramsey étant symétriques par rapport à la raie centrale de Ramsey Fr, si les fréquences Fr 10 et Fr 11 appliquées alternativement sur le tube 200 ne sont pas parfaitement symétriques de cette fréquence centrale Fr, on obtient en sortie du tube 200 alternativement deux niveaux Ni1 et Ni2 de courant dont la différence Ni traduit directement l'erreur de centrage des fréquences Fr 10 et Fr 11 par rapport à la fréquence centrale de Ramsey Fr, donc l'erreur de fréquence de l'oscillateur à quartz 100 associé au tube. Cet écart Ni peut donc être utilisé pour piloter l'asservissement de l'oscillateur 100.

L'écart Ni diminue lorsque la symétrie des fréquences Fr 10 et Fr 11 est améliorée. Il devient nul pour une symétrie parfaite des fréquences Fr 10 et Fr 11.

La phase de démarrage en vue d'un centrage sur le Rabi de Ramsey est donc poursuivie jusqu'à l'obtention d'une erreur de fréquence inférieure à un seuil déterminé, correspondant par exemple à +/- 500 Hz sur Fr.

## CENTRAGE SUR PIC DE RAMSEY

La poursuite du pic de Ramsey est opérée en appliquant sur l'entrée 202 du tube 200 alternativement, pendant les périodes de 17,92 msec successives (référencées R1, R2 sur la figure 12), un signal Fr 20, Fr 21 de fréquence égale à Fr +/- 193 Hz. Ces fréquences sont donc centrées sensiblement sur la raie centrale de Ramsey Fr. Ces fréquences Fr 20, Fr 21 sont générées en sortie des moyens de commande 300 en programmant au niveau du synthétiseur 310 des fréquences F1/N égales à F1/684 et F1/682 respectivement, soit 131 579 Hz et 131 965 Hz.

L'intégration des signaux issus du tube 200 par le circuit 420 commence, comme indiqué précédemment en regard de la figure 9, 2 msec après la commutation de fréquence, pour éliminer les effets transitoires. Elle se poursuit ensuite pendant 16 msec sous forme analogique, avant la numérisation du signal dans le convertisseur 430, puis sous forme numérique jusqu'à la constante de filtrage choisie. La différence de niveaux de courant recueilli à la sortie du tube 200 sert à piloter l'oscillateur 100.

La boucle d'asservissement de l'oscillateur 100 peut fonctionner soit selon une boucle du premier ordre avec une constante de filtrage réglable de 0,1 à 10 secondes, soit sous forme d'une boucle du deuxième ordre avec une constante de filtrage réglable de 0,5 à 100 secondes. Ce dernier mode permet d'éliminer l'erreur de phase qui peut apparaître lorsque l'oscillateur subit un choc thermique ou une variation de gravité, surtout avec des constantes de filtrage élevées.

## CYCLE DE TEST

Comme indiqué précédemment, à intervalles réguliers, deux périodes successives de 17,92 msec (référencées T1, T2 sur la figure 12) ne sont pas attribuées à la poursuite du pic de Ramsey par programmation des fréquences F1/684 et F1/682 en sortie du synthétiseur 310 soit Fr 20 et Fr 21 en sortie des moyens de commande 300, mais à une séquence de test.

Cette séquence de test peut par exemple revenir à raison de deux périodes T1, T2 de 17,92 msec, sur 18 périodes, soit toutes les 322,56 msec. L'insertion de cette séquence de test est rendue possible par le fait que la constante de temps de la boucle d'asservissement de l'oscillateur est grande par rapport au cycle de mesure comprenant deux périodes R1, R2 successives.

Au cours de ces périodes de test T1, T2, l'unité centrale 500 peut programmer alternativement 11 fréquences différentes $F_1/N$ permettant successivement a) un asservissement de l'écart de fréquence Ramsey-Zeeman, b) une mesure du niveau du pic de Ramsey par rapport à la ligne de base, c) une mesure du niveau du pic de Zeeman, d) un contrôle de la symétrie du pied du pic de Ramsey, et e) un contrôle de la symétrie du Rabi de Ramsey.

### a) Asservissement de l'écart de fréquence Ramsey-Zeeman;

La fréquence centrale de Ramsey Fr étant déterminée par l'asservissement principal il faut pour contrôler l'écart de fréquence Ramsey-Zeeman définir la fréquence centrale de Zeeman.

Cette recherche est opérée d'une manière similaire à l'asservissement principal à savoir qu'elle comprend une phase initiale de précentrage sur le Rabi de Zeeman suivie d'une phase de poursuite de la raie fine de Zeeman.

La phase initiale de précentrage sur le Rabi de Zeeman est réalisée en appliquant sur le tube 200, au cours de périodes de test T1, T2, successives, alternativement des fréquences de test Fz 10, Fz 11 grossièrement symétriques de la raie centrale de Zeeman, par exemple de l'ordre de la fréquence centrale de Zeeman +/- 7KHz. Ces fréquences Fz 10 et Fz 11 sont générées en sortie des moyens de commande 300 en programmant au niveau du synthétiseur 310, des fréquences F1/N égales à F1/525 et F1/486 soit 171 429 Hz et 185 185 Hz.

La phase de poursuite de la raie fine de Zeeman est réalisée en appliquant sur le tube 200, au cours d'autres périodes de test T1, T2, successives, alternativement des fréquences Fz 20 et Fz 21 sensiblement centrées sur la fréquence centrale de Zeeman, par exemple de l'ordre de la fréquence centrale de Zeeman +/- 300 Hz. Ces fréquences Fz 20 et Fz 21 sont générées en sortie des moyens de commande 300 en programmant au niveau du synthétiseur 310, des fréquences F1/N égales à F1/506 et F1/504 soit 177 866 Hz et 178 571 Hz.

Cet asservissement permet d'optimiser et de réguler l'écart de fréquence Ramsey-Zeeman par contrôle du courant appliqué sur l'entrée auxiliaire 206 du tube 200 en vue de générer le champ C. Cette fonction d'asservissement est de préférence déconnectable au gré de l'utilisateur. Elle permet d'éliminer la plupart des perburbations extérieures agissant classiquement sur le tube 200, en particulier les influences du champ terrestre, les effets de la température et de magnétisation du tube, les instabilités du courant de champ C.

b) Contrôle du niveau du pic Ramsey par rapport au niveau de la ligne de base.

Ce contrôle est opéré au cours de périodes de test T1, T2, par exemple toutes les 3225 msec en appliquant alternativement sur l'entrée 202 du tube un signal de fréquence Fr centrée sur la fréquence centrale de Ramsey et un signal de fréquence Fb, correspondant à la ligne de base et sensiblement centrée sur l'écart Ramsey-Zeeman. Ces fréquences Fr et Fb sont générées en sortie des moyens de commande 300, en programmant successivement en sortie du synthétiseur 310 des fréquences F1/683 et F1/580, soit 131 772 Hz et 155 172 Hz.

La différence de niveau entre les signaux obtenus en sortie du tube 200 en appliquant respectivement les deux fréquences Fr et Fb précitées permet d'obtenir directement le niveau du pic de Ramsey par rapport à la ligne de base. Ce niveau est régulé en corrigeant le gain d'entrée de la boucle de réaction. Ce contrôle permet une stabilisation des gains de boucle et des niveaux d'alarme malgré le vieillissement du tube.

c) Contrôle du niveau du pic de Zeeman

Ce contrôle peut être opéré an appliquant sur l'entrée 202 du tube 200 au cours de périodes de test T1 et T2 une fréquence Fz centrée sur la fréquence centrale de Zeeman et le signal de fréquence Fb correspondant à la ligne de base, par exemple en programmant sur le synthétiseur 310 alternativement une fréquence F1/N égale à F1/505 et F1/560, soit 178 218 Hz et 155 172 Hz.

Le contrôle du niveau du pic de Zeeman permet de contrôler le bon fonctionnement, en particulier le vieillissement, du tube.

d) Contrôle de la symétrie du pic de Ramsey

Pour éviter de centrer l'oscillateur à quartz 100 sur la base d'une oscillation parasite amortie juxtaposée au pic central de Ramsey, on peut appliquer séquentiellement sur l'entrée 202 du tube 200, au cours de périodes de test T1, T2, des fréquences Fr 30, Fr 31 symétriques de la raie centrale de Ramsey et correspondant à la base du pic de Ramsey, par exemple à Fr +/- 386 Hz. Les fréquences Fr 30 et Fr 31 peuvent être générées à la sortie des moyens de commande 300, en programmant alternativement sur le synthétiseur 310 des fréquences F1/N égales à F1/685 et F1/681, soit 131 387 Hz et 132 159 HZ.

e) Contrôle du Rabi de Ramsey

De façon similaire, un contrôle du centrage global de l'oscillateur à quartz sur le Rabi de Ramsey peut être obtenu en appliquant sur le tube, au cours de périodes de test successives T1, T2 des fréquences Fr 10 et Fr 11 similaires aux fréquences utilisées lors de la phase initiale de démarrage.

De préférence l'unité centrale 500 permet également de piloter la tension d'offset du préamplificateur 410, de réguler le niveau du signal F4 et de contrôler la puissance du signal appliqué sur l'entrée 202 du tube pour obtenir un signal maximum en sortie du tube.

La tension de correction d'offset appliquée sur la résistance R 414, tension qui est prélevée en sortie du convertisseur numérique analogique 440 correspond à la moyenne des niveaux maximum et minimum obtenus en sortie de l'intégrateur 420 au cours de deux périodes de contrôle R1, R2 successives.

La régulation du niveau du signal F4 est réalisée pour maintenir une profondeur de modulation maximale sur la fonction de Bessel J1. Pour cela, l'unité centrale pilote directement le gain de l'étage de sortie du mélangeur 374 ou d'un étage amplificateur 377 intercalé entre les mélangeurs 374 et 375.

Une régulation similaire peut être opérée sur le signal F3, en contrôlant le gain de l'étage de sortie du mélangeur 321.

De même de contrôle de la puissance du signal appliqué sur l'entrée 202 du tube pour obtenir un signal maximum de sortie du tube est réalisé en pilotant le gain de l'étape de sortie 302 des moyens de commande 300. On notera sur ce point que jusqu'ici on se plaçait aux deux tiers du gain max possible pour éviter la saturation.

Outre les fonctions précédentes, l'unité centrale peut mesurer diverses tensions de service et températures, générer différents niveaux d'alarme et couper l'alimentation du tube 200 en cas de défaut majeur.

Bien entendu la présente invention n'est pas limitée au mode de réalisation particulier qui vient d'être décrit mais s'étend à toutes variantes conformes à son esprit.

L'horloge atomique conforme à la présente invention permet une analyse précise et fiable du pic central de la réponse de Ramsey ainsi qu'une analyse globale de cette réponse permet, un réglage fin de fréquence sans intervention sur le champ C, permet de stabiliser les paramètres sensibles afin de réduire les influences de l'environnement, permet de réduire les dérives liées au vieillissement du tube et permet de réduire la dispersion de caractéristiques entre modules pour faciliter l'interchangeabilité et la maintenance.

## Revendications

1. Horloge atomique du type comprenant :
– un oscillateur à quartz (100),
– un tube (200) contenant un matériau dont les atomes présentent une transition spectrale hyperfine,
– des moyens de commande (300) aptes à générer, à partir de l'oscillateur à quartz (100), un signal de commande dont la fréquence correspond à la transition spectrale hyperfine et à appliquer ce signal de commande sur le tube (200) pour faire interagir ce signal et les atomes du matériau contenu dans le tube, les moyens de commande (300) étant adpatés pour générer des signaux de test dont la fréquence contrôlée est située à l'extérieur du pic de Ramsey et
– des moyens d'asservissement (400) sensibles à la réponse du tube (200) et adaptés pour modifier la fréquence de l'oscillateur à quartz (100) de façon à centrer sensiblement la fréquence du signal de commande sur la fréquence de la transition spectrale hyperfine,
caractérisée par le fait que
lors d'une phase de démarrage, les moyens de commande (300) appliquent alternativement sur le tube (200), deux signaux de commande dont les fréquences (Fr 10, Fr 11) sont supposées symétriques de la raie centrale de Ramsey (Fr) et les moyens d'asservissement (400) modifient la fréquence de l'oscillateur à quartz (100) pour minimiser l'écart entre les réponses du tube (200) à ces deux signaux de commande.

2. Horloge atomique selon la revendication 1, caractérisée par le fait que le tube (200) est un tube au césium.

3. Horloge atomique selon l'une des revendications 1 ou 2, caractérisée par le fait que les moyens de commande (300) comprennent un synthétiseur de fréquence (310) à commutation rapide contrôlé par microprocesseur ayant des pas de fréquence faibles.

4. Horloge atomique selon la revendication 3, caractérisé par le fait que la plage de fonctionnement du synthétiseur de fréquence (310) est de l'ordre de 55 KHz.

5. Horloge atomique selon l'une des revendications 3 ou 4, caractérisée par le fait que les pas de fréquence du synthétiseur (310) sont de l'ordre de 150 à 380 Hz.

6. Horloge atomique selon l'une des revendications 1 à 5, caractérisée par le fait que les moyens de commande comprennent :
– des moyens (301) pour définir un signal de base F1 de 90 MHz,
– des moyens synthétiseurs (310) pour définir un signal de fréquence programmable 90 MHz/N,
– des moyens pour additionner le signal de fréquence programmable 90 MHz/N avec un signal de 12,5 MHz, puis un signal de 90 MHz et à multiplier la fréquence du signal obtenu par 102.

7. Horloge atomique selon la revendication 6, caractérisée par le fait que le nombre N est programmable de 504 à 710.

8. Horloge atomique selon l'une des revendications 1 à 7, caractérisée par le fait que les fréquences (Fr 10, Fr 11) des deux signaux de commande générés par les moyens de commande (300) lors de la phase de démarrage sont comprises dans le Rabi de Ramsey.

9. Horloge atomique selon la revendication 8, caractérisée par le fait que les deux fréquences Fr 10, Fr 11 générées alternativement par les moyens de commande (300) sont de l'ordre de Fr +/- 5KHz, Fr représentant la fréquence de la transition spectrale hyperfine.

10. Horloge atomique selon l'une des revendications 8 et 9 combinée avec la revendication 6, caractérisée par le fait que les deux fréquences Fr 10, Fr 11 générées alternativement par les moyens de commande (300) sont obtenues en programmant alternativement des signaux 90 MHz/710 et 90 MHz/658 sur les moyens synthétiseurs (310).

11. Horloge atomique selon l'une des revendications 1 à 10, caractérisée par le fait que les moyens de commande (300) sont adaptés pour générer, lors de la poursuite de la raie centrale de Ramsey, alternativement deux fréquences principales Fr 20, Fr 21 sensiblement symétriques par rapport à la raie centrale de Ramsey et comprises dans le pic de Ramsey.

12. Horloge atomique selon la revendication 11, caractérisée par le fait que les deux fréquences principales Fr 20, Fr 21 générées alternativement par les moyens de commande sont de l'ordre de Fr +/- 193 Hz, Fr représentant la fréquence de la transition spectrale hyperfine.

13. Horloge atomique selon l'une des revendications 11 et 12 combinée avec la revendication 6, caractérisée par le fait que les deux fréquences principales Fr 20, Fr 21 générées alternativement par les moyens de commande (300) sont obtenues en programmant alternativement des signaux 90 MHz/684 et 90 MHz/682 sur les moyens synthétiseurs (310).

14. Horloge atomique selon l'une des revendications 1 à 13, caractérisée par le fait que les moyens de commande (300) génèrent alternativement, au cours de périodes de cadencement successives (R1, R2), deux fréquences principales Fr 20, Fr 21 sensiblement symétriques par rapport à la raie centrale de Ramsey et comprises dans le pic de Ramsey, les deux fréquences principales Fr 20, Fr 21 étant remplacées à intervalles réguliers (T1, T2) par des fréquences de test (Fr 10, Fr 11, Fr, Fr 30, Fr 31 ; Fz, Fz 10, Fz 11, Fz 20, Fz 21, Fb).

15. Horloge atomique selon la revendication 14, caractérisée par le fait que les fréquences de test comprennent au moins une paire de fréquences symétriques (Fz 10, Fz 11 ; Fz 20, Fz 21)de la raie de Zeeman.

16. Horloge atomique selon la revendication 15, caractérisée par le fait que les fréquences de test comprennent une première paire de fréquences (Fz 10, Fz 11) symétriques de la raie de Zeeman et comprises dans le Rabi de Zeeman et une seconde paire de fréquences (Fz 20, Fz 21) symétriques de la raie de Zeeman et comprises dans le pic de Zeeman.

17. Horloge atomique selon l'une des revendications 15 ou 16, caractérisée par le fait que les fréquences de test comprennent une première paire de fréquences (Fz 10, Fz 11) de l'ordre de Fz +/- 7 KHz et une seconde paire de fréquences (Fz 20, Fz 21) de l'ordre de Fz +/- 300 Hz.

18. Horloge atomique selon l'une des revendications 15 à 17 combinée avec la revendication 6, caractérisée par le fait que les fréquences de test comprennent une première paire de fréquences Fz 10, Fz 11 définies en programmant alternativement 90 MHz/525 et 90 MHz/486 sur les moyens synthétiseurs (310) et une seconde paire de fréquences Fz 20, Fz 21 définies en programmant alternativement 90 MHz/506 et 90 MHz/504 sur les moyens synthétiseurs (310).

19. Horloge atomique selon l'une des revendications 15 à 18, caractérisée par le fait que les fréquences de test Fz 10, Fz 11 ; Fz 20, Fz 21 centrées sur la raie de Zeeman sont utilisées pour un asservissement de l'écart de fréquence Ramsey-Zeeman, par contrôle du champ C sur le tube (200).

20. Horloge atomique selon l'une des revendications 14 à 19, caractérisée par le fait que les fréquences de test comprennent une fréquence Fr centrée sur la raie de Ramsey et une fréquence Fb centrée sur l'intervalle Ramsey-Zeeman.

21. Horloge atomique selon la revendication 20, caractérisée par le fait que la fréquence Fr centrée sur la raie de Ramsey est définie en programmant la fréquence 90 MHz/683 sur les moyens synthétiseurs (310) et la fréquence Fb centrée sur l'intervalle Ramsey-Zeeman est définie en programmant la fréquence 90 MHz/580 sur les moyens synthétiseurs (310).

22. Horloge atomique selon l'une des revendications 20 ou 21, caractérisée par le fait que le gain d'entrée des moyens d'asservissement (400) est réglé pour maintenir constante la différence de niveaux des signaux de sortie du tube lors de l'application successive de la fréquence Fr centrée sur la raie de Ramsey et de la fréquence Fb centrée sur l'intervalle Ramsey-Zeeman.

23. Horloge atomique selon l'une des revendications 14 à 22, caractérisée par le fait que les fréquences de test possèdent une fréquence Fz centrée sur le pic de Zeeman.

24. Horloge atomique selon la revendication 23 combinée avec la revendication 6, caractérisée par le fait que la fréquence Fz centrée sur le pic de Zeeman est définie en programmant la fréquence 90 MHz/505 sur les moyens synthétiseurs (310).

25. Horloge atomique selon l'une des revendications 14 à 24, caractérisée par le fait que les fréquences de test possèdent deux fréquences (Fr 30, Fr 31) symétriques de la raie de Ramsey et situées à la base du pic de Ramsey.

26. Horloge atomique selon la revendication 25, caractérisée par le fait que les fréquences de test Fr 30, Fr 31 situées à la base du pic de Ramsey sont de l'ordre de Fr +/- 386 Hz, Fr représentant la fréquence de la transition spectrale hyperfine.

27. Horloge atomique selon l'une des revendications 25 ou 26 combinée avec la revendication 6, caractérisée par le fait que les fréquences Fr 30, Fr 31 situées à la base du pic de Ramsey sont définies en programmant alternativement les fréquences 90 MHz/685 et 90 MHz/681 sur les moyens synthétiseurs (310).

28. Horloge atomique selon l'une des revendications 14 à 27, caractérisée par le fait que les fréquences de test comprennent deux fréquences Fr 10, Fr 11 sensiblement symétriques par rapport à la raie centrale de Ramsey et comprises dans le Rabi de Ramsey conformes à l'une des revendications 8 et 9.

29. Horloge atomique selon l'une des revendications 1 à 28, caractérisée par le fait que les moyens de commande (300) comprennent un vernier (350) permettant un réglage fin de la fréquence du signal de commande.

30. Horloge atomique selon la revendication 29, caractérisée par le fait que le vernier (350) comprend:
  – un premier générateur de rampe (352) récurrent à une fréquence de l'ordre de la fréquence de base du signal de commande,
  – un second générateur de rampe (354) récurrent à la fréquence de cadencement des moyens de commande,
  – des moyens (500) pour programmer l'amplitude et la polarité de la pente de la rampe issue du second générateur (354), et
  – un comparaeur (356) dont les entrées reçoivent respectivement les rampes issues des deux générateurs (352, 354).

31. Horloge atomique selon l'une des revendications 1 à 30, caractérisée par le fait qu'elle comprend des moyens amplificateurs-intégrateurs connectés entre la sortie (204) du tube et un convertisseur analogique/numérique (430), ces moyens amplificateurs-intégrateurs, comportant:
– une porte analogique (425) à quatre entrées et une sortie, et
– un étage intégrateur (OP 423),
tels que deux états de la porte analogique permettent un choix de gain par commutation de résistances (R 421, R 422), un troisième état de la porte permette une mémorisation du niveau obtenu sur la capacité d'intégration (C 424) et le quatrième état de la porte définisse la décharge de la capacité (C 424) d'intégration.

32. Horloge atomique selon l'une des revendications 1 à 31, caractérisée par le fait que l'asservissement de l'oscillateur à quartz (100) est défini par :
– un intégrateur (460) dont l'entrée est reliée à un
– un convertisseur numérique/analogique (440) par l'intermédiaire,
– d'une port analogique (450) à temps de fermeture contrôlé.

**Patentansprüche**

1. Atomuhr der Art, welche umfaßt:
– einen Quarzoszillator (100),
– ein Rohr (200), das ein Material enthält, dessen Atome einen spektralen Hyperfeinübergang aufweisen,
– Steuervorrichtungen (300), die geeignet sind, ausgehend von dem Quarzoszillator (100), ein Steuersignal zu erzeugen, dessen Frequenz dem spektralen Hyperfeinübergang entspricht, und dieses Steuersignal an das Rohr (200) anzulegen, um dieses Signal und die Atome des in dem Rohr enthaltenen Materials wechselwirken zu lassen, wobei die Steuerungsvorrichtungen (300) geeignet sind, Testsignale zu erzeugen, deren geregelte Frequenz sich außerhalb des Ramseypeaks befindet, und
– Regelungsvorrichtungen (400), die auf die Antwort des Rohres (200) reagieren und geeignet sind, die Frequenz des Quarzoszillators (100) so zu ändern, daß die Frequenz des Steuersignals im wesentlichen auf die Frequenz des spektralen Hyperfeinübergangs zentriert ist, gekennzeichnet durch die Tatsache, daß bei einer Startphase die Steuervorrichtungen (300) abwechselnd an das Rohr (200) zwei Steuersignale anlegen, deren Frequenzen (Fr 10, Fr 11) symmetrisch zu dem zentralen Ramseystrahl (Fr) angenommen werden, und daß die Regelungsvorrichtungen (400) die Frequenz des Quarzoszillators (400) ändern, um den Abstand zwischen den Antworten des Rohres (200) auf diese Steuersignale zu minimieren.

2. Atomuhr nach Anspruch 1, gekennzeichnet durch die Tatsache, daß das Rohr (200) ein Cäsiumrohr ist.

3. Atomuhr nach einem der Ansprüche 1 oder 2, gekennzeichnet durch die Tatsache, daß die Steuervorrichtungen (300) einen Frequenzsynthesizer (310) mit schneller Umschaltung umfassen, der von einem Mikroprozessor mit Schritten geringer Frequenz gesteuert wird.

4. Atomuhr nach Anspruch 3, gekennzeichnet durch die Tatsache, daß der Funktionsbereich des Frequenzsynthesizers (310) in der Größenordnung von 55 kHz liegt.

5. Atomuhr nach einem der Ansprüche 3 oder 4, gekennzeichnet durch die Tatsache, daß die Frequenzschritte des Synthesizers (310) in der Größenordnung von 150 bis 380 Hz liegen.

6. Atomuhr nach einem der Ansprüche 1 bis 5, gekennzeichnet durch die Tatsache, daß die Steuervorrichtungen umfassen:
– Vorrichtungen (301) zum Bilden eines Basissignals F1 von 90 MHz,
– Synthesizervorrichtungen (310) zum Bilden eines Signals mit programmierbarer Frequenz 90 MHz/N,
– Vorrichtungen zum Addieren des Signals mit programmierbarer Frequenz 90 MHz/N und eines Signal von 12,5 MHz und dann eines Signal mit 90 MHz und zum Multiplizieren der Frequenz des erhaltenen Signals mit 102.

7. Atomuhr nach Anspruch 6, gekennzeichnet durch die Tatsache, daß die Zahl N zwischen 504 und 710 programmierbar ist.

8. Atomuhr nach einem der Ansprüche 1 bis 7, gekennzeichnet durch die Tatsache, daß die Frequenzen (Fr 10, Fr 11) der beiden Steuersignale, die von den Steuervorrichtungen (300) während der Startphase erzeugt werden, in dem Rabi des Ramseypeaks liegen.

9. Atomuhr nach Anspruch 8, gekennzeichnet durch die Tatsache, daß die beiden Frequenzen Fr 10, Fr 11, die abwechselnd von den Steuervorrichtungen (300) erzeugt werden, in der Größenordnung von Fr +/- 5 kHz liegen, wobei Fr die Frequenz des spektralen Hyperfeinübergangs darstellt.

10. Atomuhr nach einem der Ansprüche 8 und 9 kombiniert mit Anspruch 6, gekennzeichnet durch die Tatsache, daß die beiden Frequenzen Fr 10, Fr 11, die abwechselnd von den Steuervorrichtungen (300) erzeugt werden, erhalten werden, indem abwechselnd Signale 90 MHz/710 und 90 MHz/658 auf den Synthesizervorrichtungen (310) programmiert werden.

11. Atomuhr nach einem der Ansprüche 1 bis 10, gekennzeichnet durch die Tatsache, daß die Steuervorrichtungen (300) geeignet sind, während der Verfolgung des zentralen Strahls des Ramseypeaks abwechselnd zwei Hauptfrequenzen Fr 20, Fr 21 zu erzeugen, die im wesentlichen symmetrisch zum zentralen Strahl des Ramseypeaks sind und in dem Ramseypeak liegen.

12. Atomuhr nach Anspruch 11, gekennzeichnet durch die Tatsache, daß die beiden Hauptfrequenzen Fr 20, Fr 21, die abwechselnd von den Steuervorrichtungen (300) erzeugt werden, in der Größenordnung von Fr +/- 193Hz liegen, wobei Fr die Frequenz des spektralen Hyperfeinübergangs darstellt.

13. Atomuhr nach einem der Ansprüche 11 und 12 kombiniert mit Anspruch 6, gekennzeichnet durch die Tatsache, daß die beiden Hauptfrequenzen Fr 20, Fr 21, die abwechselnd von den Steuervorrichtungen (300) erzeugt werden, erhalten werden, indem abwechselnd Signale 90 MHz/684 und 90 MHz/662 auf den Synthesizervorrichtungen (310) programmiert werden.

14. Atomuhr nach einem der Ansprüche 1 bis 13, gekennzeichnet durch die Tatsache, daß Steuervorrichtungen (300) abwechselnd während aufeinanderfolgender Taktperioden (R1, R2) zwei Hauptfrequenzen Fr 20, Fr 21 erzeugen, die im wesentlichen symmetrisch zum zentralen Strahl des Ramseypeaks sind und in dem Ramseypeak liegen, wobei die beiden Hauptfrequenzen Fr 20, Fr 21 in regelmäßigen beständen (T1, T2) von Testfrequenzen (Fr 10, Fr 11, Fr, Fr 30, Fr 31; Fz, Fz 10, Fz 11, Fz 20, Fz 21, Fb) ersetzt werden.

15. Atomuhr nach Anspruch 14, gekennzeichnet durch die Tatsache, daß die Testfrequenzen wenigstens ein zum Zeemanpeak symmetrisches Frequenzpaar (Fz 10, Fz 11; Fz 20, Fz 21) umfassen.

16. Atomuhr nach Anspruch 15, gekennzeichnet durch die Tatsache, daß die Testfrequenzen ein erstes Frequenzpaar (Fz 10, Fz 11), das symmetrisch zum Zeemanpeak ist und im Rabi des Zeemanpeaks liegt, und ein zweites Frequenzpaar (Fz 20, Fz 21) umfassen, das symmetrisch zum Zeemanpeak ist und im Zeemanpeak liegt.

17. Atomuhr nach einem der Ansprüche 15 und 16, gekennzeichnet durch die Tatsache, daß die Testfrequenzen ein erstes Frequenzpaar (Fz 10, Fz 11) der Größenordnung Fz +/- 7 kHz und ein zweites Frequenzpaar (Fz 20, Fz 21) der Größenordnung Fz +/- 300 Hz umfassen.

18. Atomuhr nach einem der Ansprüche 15 und 17 kombiniert mit Anspruch 6, gekennzeichnet durch die Tatsache, daß die Testfrequenzen ein erstes Frequenzpaar Fz 10, Fz 11, das erhalten wird, indem abwechselnd 90 MHz/525 und 90 MHz/486 auf den Synthesizervorrichtungen (310) programmiert werden, und ein zweites Frequenzpaar Fz 20, Fz 21 umfassen, das erhalten wird, indem abwechselnd 90 MHz/506 und 90 MHz/404 auf den Synthesizervorrichtungen (310) programmiert werden.

19. Atomuhr nach einem der Ansprüche 15 bis 18, gekennzeichnet durch die Tatsache, daß die Testfrequenzen Fz 10, Fz 11; Fz 20, Fz 21, die um den Zeemanstrahl zentriert sind, zum Regeln des Frequenzabstands Ramseypeak-Zeemanpeak durch Regelung des Feldes C auf das Rohr (200) verwendet werden.

20. Atomuhr nach einem der Ansprüche 14 bis 19, gekennzeichnet durch die Tatsache, daß die Testfrequenzen eine auf den Ramseystrahl zentrierte Frequenz Fr und eine auf das Intervall Ramseypeak-Zeemanpeak zentrierte Frequenz Fb umfassen.

21. Atomuhr nach Anspruch 20, gekennzeichnet durch die Tatsache, daß die auf den Ramseystrahl zentrierte Frequenz Fr erzeugt wird, indem die Frequenz 90 MHz/683 auf den Synthesizervorrichtungen (310) programmiert wird, und die auf das Intervall Ramseypeak-Zeemanpeak zentrierte Frequenz Fb erzeugt wird, indem die Frequenz 90 MHz/580 auf den Synthesizervorrichtungen (310) programmiert wird.

22. Atomuhr nach einem der Ansprüche 20 oder 21, gekennzeichnet durch die Tatsache, daß die Eingangsverstärkung der Regelungsvorrichtungen (400) geregelt wird, um den Unterschied der Signalpegel des Rohrausgangs beim sukzessiven Anlegen der auf den Ramseystrahl zentrierten Frequenz Fr und der auf das Intervall Ramseypeak-Zeemanpeak zentrierten Frequenz Fb konstant zu halten.

23. Atomuhr nach einem der Ansprüche 14 bis 22, gekennzeichnet durch die Tatsache, daß die Testfrequenzen eine auf den Zeemanpeak zentrierte Frequenz Fz umfassen.

24. Atomuhr nach Anspruch 23 kombiniert mit Anspruch 6, gekennzeichnet durch die Tatsache, daß die auf den Zeemanpeak zentrierte Testfrequenz erhalten wird, indem die Frequenz 90 MHz/505 auf den Synthesizervorrichtungen (310) programmiert wird.

25. Atomuhr nach einem der Ansprüche 14 bis 24, gekennzeichnet durch die Tatsache, daß die Testfrequenzen zwei Frequenzen (Fr 30, Fr 31) umfassen, die zum Ramseystrahl symmetrisch sind und sich an der Basis des Ramseypeaks befinden.

26. Atomuhr nach Anspruch 25, gekennzeichnet durch die Tatsache, daß die an der Basis des Ramseypeaks befindlichen Testfrequenzen Fr 30, Fr 31 in der Größenordnung von Fr +/- 386 Hz liegen, wobei Fr die Frequenz des spektralen Hyperfeinübergangs ist.

27. Atomuhr nach einem der Ansprüche 25 oder 26 kombiniert mit Anspruch 6, gekennzeichnet durch die Tatsache, daß die an der Basis des Ramseypeaks befindlichen Testfrequenzen Fr 30, Fr 31 erhalten werden, indem die Frequenzen 90 MHz/685 und 90 MHz/681 auf den Synthesizervorrichtungen (310) programmiert werden.

28. Atomuhr nach einem der Ansprüche 14 bis 27, gekennzeichnet durch die Tatsache, daß die Testfrequenzen zwei Frequenzen Fr 10, Fr 11 umfassen, die zum zentralen Ramseystrahl im wesentlichen symmetrisch sind und sich im Rabi des Ramseystrahls nach einem der Ansprüche 8 und 9 befinden.

29. Atomuhr nach einem der Ansprüche 1 bis 28, gekennzeichnet durch die Tatsache, daß Steuervorrichtungen (300) eine Feinstelleinrichtung aufweisen, die eine Feinregelung der Frequenz des Steuersignals erlaubt.

30. Atomuhr nach Anspruch 29, gekennzeichnet durch die Tatsache, daß die Feinstelleinrichtung (350) umfaßt:

– einen ersten Rampengenerator (352), der zu einer Frequenz zurückläuft, die der Größenordnung der Basisfrequenz des Steuersignals entspricht,

– einen zweiten Rampengenerator (354), der zu der Taktperiodenfrequenz der Steuervorrichtungen zurückläuft,

– Vorrichtungen (500) zum Programmieren der Amplitude und der Polarität der Neigung der von dem zweiten Generator (354) erzeugten Rampe, und

– einen Komparator (356), dessen Eingänge jeweils die von den beiden Generatoren (352, 354) erzeugten Rampen erhalten.

31. Atomuhr nach einem der Ansprüche 1 bis 30, gekennzeichnet durch die Tatsache, daß sie Verstärker-Integratorvorrichtungen umfaßt, die zwischen dem Ausgang (204) des Rohres und einem Analog/Digitalwandler (430) angeordnet sind, wobei diese Verstärker-Integratorvorrichtungen aufweisen:

– ein Analoggatter (425) mit vier Eingängen und einem Ausgang, und

– eine Integratorstufe (OP 423), so daß zwei Zustände des Analoggatters eine Wahl der Verstärkung durch Umschalten von Widerständen (R 421, R 422) erlauben, ein dritter Zustand des Gatters eine Speicherung des erhaltenen Pegels in einer Integrationskapazität (C 424) erlaubt und ein vierter Zustand des Gatters die Entladung des Integrationskapazität (C 424) bildet.

32. Atomuhr nach einem der Ansprüche 1 bis 31, gekennzeichnet durch die Tatsache, daß die Regelung des Quarzoszillators (100) gebildet wird durch:

– einen Integrator (460), dessen Eingang verbunden ist mit

– einem Digital/Analogwandler (440) über

– ein Analoggatter (450) mit gesteuerter Verschlußzeit.

**Claims**

1. An atomic clock of the type comprising :
– a quartz oscillator (100),
– a tube (200) containing a material, the atoms of which have an hyperfine spectral transition;
– control means (300) capable of generating, from the quartz oscillator (100), a control signal of a frequency that corresponds to the hyperfine spectral transition, and of applying this control signal to the tube (200) to cause interaction between this signal and the atoms of the material contained in the tube; the control means (300) being adapted to generate test signals, the controlled frequency of which is located outside the Ramsey peak, and
– feedback means (400) that are sensitive to the response of the tube (200) and are adapted to modifying the frequency of the quartz oscillator (100) so as to substantially center the frequency of the control signal on the frequency of the hyperfine spectral transition,
characterised by
the fact that in a starting stage, the control means (300) apply alternately to the tube (200), two control signals the frequencies (Fr10, Fr11) of which are supposed symmetrical with the central Ramsey line (Fr) and the feedback means (400) change the frequency of the quartz oscillator (100) to minimize the gap between the responses of the tube (200) for these two control signals.

2. An atomic clock according to claim 1 characterised by the fact that the tube (200) is a tube of cesium.

3. An atomic clock according to either of the claims 1 or 2, characterised by the fact that the control means (300) include a microprocessor-controlled, fast switching-over frequency synthesizer (310) having small frequency steps.

4. An atomic clock according to claim 3, characterised by the fact that the operating range of the frequency synthesizer (310) is of the order of 55 KHz.

5. An atomic clock according to one of claims 3 or 4, characterised by the fact that the frequency steps of the synthesizer (310) are of the order of 150 to 380 Hz.

6. An atomic clock according to one of claims 1 to 5, characterised by the fact that the control means include :
– means (301) to define a base signal F1 of 90 MHz,
– synthesizing means (310) to define a programmable frequency signal of 90 MHz/N,
– means to add the programmable frequency signal of 90 MHz/N to a 12.5 MHz signal, then a 90 MHz signal and to multiply the frequency of the signal obtained by 102.

7. An atomic clock according to claim 6, characterised by the fact that the number N is programmable from 504 to 710.

8. An atomic clock according to one of claims 1 to 7, characterised by the fact that the frequencies (Fr10, Fr11) of the two control signals generated by the control means (300) during the starting stage are included in the Ramsey Rabi.

9. An atomic clock according to claim 8, characterised by the fact that the two frequencies Fr10, Fr11, alternately generated by the control means (300), are of the order of Fr +/- 5 KHz, Fr representing the frequency of the hyperfine spectral transition.

10. An atomic clock according to one of claims 8

15

or 9, combined with claim 6, characterised by the fact that the two frequencies fr10, Fr11; alternately generated by the control means (300), are obtained by alternately programming 90 MHz/710 and 90 MHz/658 signals on the synthesizer means (310).

11. An atomic clock according to one of claims 1 to 10, characterised by the fact that the control means (300) are adapted to alternately generating, when the central Ramsey line is being followed, two main frequencies Fr20, Fr21, which are substantially symmetrical with respect to the central Ramsey line, and are included in the Ramsey peak.

12. An atomic clock according to claim 11, characterised by the fact that the two main frequencies Fr20, Fr21, alternately generated by the control means, are of the order of Fr +/-193 Hz, Fr representing the frequency of the hyperfine spectral transition.

13. An atomic clock according to one of claims 11 or 12, combined with claim 6, characterised by the fact that the two main frequencies Fr20, Fr21, alternately generated by the control means (300), are obtained by alternately programming 90 MHz/684 and 90 MHz/682 signals on the synthesizing means (310).

14. An atomic clock according to one of claims 1 to 13, characterised by the fact that the control means (300) alternately generate, during successive rate-setting periods (R1, R2), two main frequencies Fr20, Fr21 which are substantially symmetrical with respect to the central Ramsey line and are included in the Ramsey peak, the two main frequencies Fr20, Fr21 being replaced at regular intervals (T1, T2) by test frequencies, (Fr10, Fr11, Fr, Fr30, Fr31; Fz, Fz10, Fz11, Fz20, Fz21, Fb.).

15. An atomic clock according to claim 14, characterised by the fact that the test frequencies comprise at least one pair of frequencies, (Fz10, Fz11; Fz20, Fz21), symmetrical with the Zeeman line.

16. An atomic clock according to claim 15, characterised by the fact that the test frequencies comprise a first pair of frequencies (Fz10, Fz11), symmetrical with the Zeeman line and included in the Zeeman Rabi, and a second pair of frequencies, (Fz20, Fz21), symmetrical with the Zeeman line and included in the Zeeman peak.

17. An atomic clock according to one of claims 15 or 16, characterised by the fact that the test frequencies comprise a first pair of frequencies, (Fz10, Fz11), of the order of Fz +/-7 KHz and a second pair of frequencies,(Fz20, Fz21), of the order of Fz +/- 300 Hz.

18. An atomic clock according to one of claims 15 to 17, combined with claim 6, characterised by the fact that the test frequencies comprise a first pair of frequencies Fz10, Fz11, defined in alternately programming 90 MHz/525 and 90 MHz/486 on the synthesizer means (310) and a second pair of frequencies Fz20, Fz21 defined in alternately programming 90 MHz/506 and 90 MHz/504 on the synthesizer means.

19. An atomic clock according to one of claims 15 to 18, characterized by the fact that the test frequencies Fz10, Fz11; Fz20, Fz21, centered on the Zeeman line, are used for a feedback control of the Ramsey-Zeeman frequency difference through the control of the field C on the tube (200).

20. An atomic clock according to one of claims 14 to 19, characterised by the fact that the test frequencies comprise a frequency Fr centered on the Ramsey line and a frequency Fb centered on the Ramsey-Zeeman interval.

21. An atomic clock according to claim 20, characterised by the fact that the frequency Fr centered on the Ramsey line is defined by programming the frequency 90 MHz/683 on the synthesizer means (310) and the frequency Fb centered on the Ramsey-Zeeman interval is defined by programming the frequency of 90 MHz/580 on the synthesizer means (310).

22. An atomic clock according to claim 20 or 21, characterised by the fact that the input gain of the feedback means (400) is set to maintain, at a constant value, the difference in the levels of the output signals of the tube during the successive application of the frequency Fr, centered on the Ramsey line, and the frequency Fb, centered on the Ramsey-Zeeman interval.

23. An atomic clock according to one of claims 14 to 22, characterised by the fact that the test frequencies have a frequency Fz centered on the Zeeman peak.

24. An atomic clock according to claim 23, combined with claim 6, characterised by the fact that the frequency Fz centered on the Zeeman peak is defined by programming the 90 MHz/505 frequency on the synthesizer means (310).

25. An atomic clock according to one of claims 14 to 24, characterised by the fact that the test frequencies have two frequencies (Fr30, Fr31), symmetrical with the Ramsey line and located at the base of the Ramsey peak.

26. An atomic clock according to claim 25, characterised by the fact that the test frequencies Fr30, Fr31 located at the base of the Ramsey peak are of the order of Fr +/-386 Hz, Fr representing the frequency of the hyperfine spectral transition.

27. An atomic clock according to claim 25 or 26 combined with claim 6, characterised by the fact that the frequencies Fr30, Fr31, located at the base of the Ramsey peak, are defined by alternately programming the 90 MHz/685 and 90 MHz/681 frequencies on the synthesizer means (310).

28. An atomic clock according to one of claims 14 to 27, characterised by the fact that the test frequencies comprise two frequencies Fr10, Fr11, which are substantially symmetrical with respect to the central Ramsey line and are included in the Ramsey Rabi according to claim 8 or 9.

29. An atomic clock according to one of claims 1 to 28, characterised by the fact that the control means (300) include a vernier (350) enabling a fine tuning of the frequency of the control signal.

30. An atomic clock according to claim 29, characterised by the fact that the vernier (350) comprises :

– a first slope generator (352) recurrent at a frequency of the order of the basic frequency of the control signal,

– a second slope generator (354) recurrent at the rate-setting frequency of the control means,

– means (500) to program the amplitude and polarity of the inclination of the slope coming from the second generator (354), and

– a comparator (356), the inputs of which respectively receive the slopes coming from the two generators (352, 354).

31. An atomic clock according to one of claims 1 to 30, including amplifier/integrator means connected between the output (204) of the tube and an analog/ digital converter (430), said amplifier/integrator means comprising :

– an analog gate (425) with four inputs and one output, and

– an integrator stage (OP423) such that two states of the analog gate enable a choice of gain by switching over of resistors (R421, R422), a third state of the gate enables a memorizing of the level obtained at the integration capacitor (C424) and the fourth state of the gate defines the discharge of the integration capacitor (C424).

32. An atomic clock according to one of claims 1 to 31, characterised by the fact that the feedback of the quartz oscillator (100) is defined by :

– an integrator (460) with its input connected to a

– digital/analog converter (440) by means of

– an analog gate (450) with a controlled closing time.

# FIG_1

$$F_1 / N$$
$$(F_2 \pm dF)/2$$

- 500 -

FIG_2

REPONSE DE RAMSEY

Fr — Pic de Ramsey

Rabi de Ramsey

Pic de Zeeman

Rabi de Zeeman

Fr 10

Fr 11

Fz — Pic de Zeeman

Fz 10

Ligne de Base

Rabi de Ramsey

Fb

Fz 11

Rabi de Zeeman

EP 0 331 577 B1

# FIG_3

Fr

Pic de Ramsey

Fr 20

Fr 21

Rabi de Ramsey

Rabi de Ramsey

Fr 10

Fr 30

Fr 31

Fr 11

ΔFr

EP 0 331 577 B1

## FIG_4    LOUPE SUR LE PIC ZEEMAN

## FIG_5

FIG_6

## FIG_7

## FIG_8

FIG.9

FIG.10

EP 0 331 577 B1

FIG. 11

440

502

442

400

450

R462

C463

OP461

460

102

100

Centrage sur Pic Ramsey et tests périodiques

démarrage

démarrage

D₁    D₂    D₁

$F_1/710$   $F_1/658$   $F_1/710$

Centrage
sur Pic Ramsey

R₁    R₂    R₁

$F_1/684$   $F_1/682$   $F_1/684$

Test

R₂    T₁    T₂    R₁

$F_1/525$   $F_1/486$

$F_1/682$   $F_1/684$

FIG. 12

# FIG_13